(19) Europäisches Patentamt
European Patent Office
Office européen des brevets

(11) **EP 2 425 445 B1**

(12) **EUROPÄISCHE PATENTSCHRIFT**

(45) Veröffentlichungstag und Bekanntmachung des Hinweises auf die Patenterteilung:
**20.04.2016 Patentblatt 2016/16**

(21) Anmeldenummer: **10747406.6**

(22) Anmeldetag: **27.04.2010**

(51) Int Cl.:
***H01J 37/32*** *(2006.01)*

(86) Internationale Anmeldenummer:
**PCT/EP2010/002562**

(87) Internationale Veröffentlichungsnummer:
**WO 2010/124836 (04.11.2010 Gazette 2010/44)**

(54) **VERFAHREN ZUR ERZEUGUNG EINES PLASMASTRAHLS SOWIE PLASMAQUELLE**

METHOD FOR PRODUCING A PLASMA JET AND PLASMA SOURCE

PROCÉDÉ DE PRODUCTION D'UN JET DE PLASMA ET SOURCE DE PLASMA

(84) Benannte Vertragsstaaten:
**AT BE BG CH CY CZ DE DK EE ES FI FR GB GR HR HU IE IS IT LI LT LU LV MC MK MT NL NO PL PT RO SE SI SK SM TR**

(30) Priorität: **28.04.2009 DE 102009018912**

(43) Veröffentlichungstag der Anmeldung:
**07.03.2012 Patentblatt 2012/10**

(73) Patentinhaber: **Bühler Alzenau GmbH**
**63755 Alzenau (DE)**

(72) Erfinder:
• **SCHERER, Michael**
**63796 Kahl (DE)**

• **PISTNER, Jürgen**
**63755 Alzenau-Michelbach (DE)**

(74) Vertreter: **Pohlmann, Bernd Michael**
**RPK Patentanwälte**
**Reinhardt, Pohlmann und Kaufmann**
**Partnerschaft mbB**
**Rossmarkt 12**
**60311 Frankfurt am Main (DE)**

(56) Entgegenhaltungen:
**WO-A2-2004/091264      US-A- 5 156 703**
**US-A1- 2003 106 643      US-B1- 6 167 835**

**Beschreibung**

Die Erfindung bezieht sich auf ein Verfahren zur Erzeugung eines Plasmastrahls sowie auf eine Plasmaquelle zum Durchführen des Verfahrens jeweils nach den Merkmalen der Oberbegriffe der unabhängigen Patentansprüche.

Mit Hochfrequenz (HF) in einem Frequenzbereich zwischen 1 MHz und 20 MHz angeregte Plasmaquellen und mit einem durch ein Gitter abgeschlossenen Plasmaraum, aus dem ein Plasmastrahl extrahiert wird, sind bekannt, wobei zwischen induktiver und kapazitiver Anregung des üblicherweise von einem Magnetfeld beaufschlagten Plasmas unterschieden wird. Bei derartigen induktiv und gemischt induktiv/kapazitiv angeregten Hochfrequenz-Plasmaquellen werden modifizierte Helmholzspulen eingesetzt, die im wesentlichen homogene Felder, die senkrecht zu einer Induktions- HF-Einkopplungsspule oder Windung erzeugen und zu einer Erhöhung der Plasmadichte führen.

Aus der DE 694 210 33 T2 ist beispielsweise eine im Radiofrequenzbereich (RF) betriebene induktive Plasmaquelle bekannt, bei der bei einer reduzierten Anzahl von Systemkomponenten die Plasmadichte durch außerhalb einer Vakuumkammer angeordnete Permanent-Magnete erhöht wird.

Aus der DE 100 084 82 A1 ist eine HF- Plasmaquelle mit einer

Magnetfeldspulenanordnung und einer Einheit zur Extraktion eines Plasmastrahls bekannt, wobei einer Anregungselektrode ein transversales Magnetfeld überlagert ist, und zur Erzeugung eines transversalen Magnetfeldes Magnetfeldspulen um ein Plasmavolumen herum angeordnet sind. Dabei kann zwischen kapazitiver und induktiver Plasmaanregung gewählt werden wobei die Ionen- Energie bei einem Bereich von 10 eV bis etwa 1000 eV eingestellt werden kann.

Eine weiterePlasmaquelle mit einer Magnetfeldspulenanordnung und einer Einheit zur Extraktion eines Plasmastrahls ist aus der US5156703A bekannt.

Eine kapazitiv gekoppelte Plasmaquelle ist aus der EP 0349556 B1 bekannt, wonach ein Plasmastrahl beispielsweise zur Abtragung und Strukturierung von Festkörperoberflächen, zur Herstellen von Oberflächen-Dotierungen durch Teilchenbeschuß oder zum Erzeugen von Oberflächenschichten extrahiert werden kann. Diese bekannte Plasmaquelle umfasst ein Plasmagefäß, welches einen Plasmaraum umgibt, sowie zwei großflächige Elektroden, die über ein Anpassungs-Netzwerk mit einem Hochfrequenz-Generator verbunden sind. Die Flächen der Elektroden sind so gewählt, dass nahezu die gesamte Hochfrequenz-Spannung an der Extraktionselektrode abfällt. Die Extraktionselektrode ist in einer Öffnung des topfförmigen Plasmagefäß angeordnet. An der anderen Elektrode, die als Ankoppel-Elektrode dient, wird eine Hochfrequenzspannung angelegt, wobei die Extraktionselektrode auf Masse-Potenzial liegt. Im Plasmaraum wird bei Anlegen der Hochfrequenzspannung an die Anregungselektrode und Zuführen eines Prozess-Gases in dem Plasmaraum ein Plasma gezündet. Das Plasma legt sich gegenüber der Extraktionselektrode von selbst auf ein höheres, positives Potenzial, wobei Ionen des Plasmas auf die in Kontakt mit dem Plasma stehende Extraktions-Elektrode hin beschleunigt werden und durch die Extraktionselektrode hindurchtreten. Der durch die Extraktionselektrode extrahierte Ionenstrom wird durch einen im Takt der Hochfrequenz fließenden Elektrodenstrom in gleicher Größe überlagert, sodass im zeitlichen Mittel ein elektrisch neutraler Plasmastrahl aus der Plasmaquelle extrahiert wird. Derartige HF Plasmaquellen werden üblicherweise für Ionen-Energien zwischen 50 eV und 100 eV und in einem Arbeitsdruckbereich zwischen $10^{-4}$ mbar und $10^{-2}$ mbar eingesetzt. Zur Verbessung der Eigenschaften der Plasmaquelle wird in dem genannten Dokument vorgeschlagen, dem Plasmagefäß geeignet geformte axiale Gleichmagnetfelder zu überlagern, indem das Plasmagefäß von außen durch Einsatz von Magnetfeldspulen umgeben wird, in denen das Plasmagefäß konzentrisch angeordnet ist. Dabei können in den Bereichen, in denen die Magnetfeld-Linien parallel zu den Wänden des Plasmagefäßes verlaufen, die Diffusionsbewegung von Plasmateilchen zu den Wänden eingeschränkt werden, wodurch Wandverluste stark reduziert werden und die Plasmadichte erhöht werden kann. Dies wiederum dient einer Erhöhung der Ionen- und Elektronenstromdichte im extrahierten Plasma-Strahl. Üblicherweise werden zwei Solenoid-Spulen um das Plasmagefäß angeordnet, wobei ein besonders effektiver Elektroneneinschluss und damit eine hohe Plasmadichte erreicht wird, wenn gegenläufige Ströme, d.h. sich abstoßende Magnetfelder im Plasmagefäß erzeugt werden.

Aus der WO 2005/008717 ist eine kapazitiv angeregte HF- Plasmaquelle zur Erzeugung eines durch Magnetfelder geformten Plasmastrahls bekannt, bei dem durch ein homogenes Magnetfeld eine Erhöhung der Plasmadichte und damit ein Betrieb der Quelle bei relativ niedrigen Plasmadrücken ermöglicht wird, wobei zur Erzeugung des Magnetfelds ein Spulensatz oder Permanent-Magnete vorgesehen sind.

Die bekannten induktiv und/ oder kapazitiv angeregten HF- Plasmaquellen stellen kostenintensive Lösungen dar, benötigen aufgrund des Einsatzes der erwähnten Magnetfeldspulen viel Platz und weisen einen komplizierten Aufbau auf, so dass eine Größenskalierung zur Plasmabehandlung von großflächigen Substraten, beispielsweise als Rechteck-Quellen für den Einsatz in Architekturglas-Beschichtungsanlagen oder Trommelanlagen wenig geeignet sind.

Zur Beschichtung und zum Ätzen von Oberflächen, die sehr nahe an einen Plasmaraum herangeführt werden können, sind auch gitterlose HF- Plasmaquellen mit einem von Magnetfeldern beaufschlagtem Plasma bekannt. So offenbart beispielsweise die DE 41 096 19 C1 eine HF- Plasmaquelle mit zwei Elektroden, von denen die erste als Hohlelektrode und die zweite ein Substrat zu tragende Elektrode den Hohlraum der ersten Elektrode vorgelagert ist. Die Hohlelektrode ist von einer Dunkelraum-Abschirmung umgeben und weist in Richtung der zweiten Elektrode zeigende Ränder auf, zwischen denen Vorsprünge vorgesehen sind, die auf gleichen elektrischen Potenzial wie die erste Elektrode liegen. Zwischen den Vorsprüngen sind Permanent-Magnete vorgesehen, mit denen eine Substratvorspannung unabhängig von der Entladungs-Geometrie, dem Entladungsdruck und der Hochfrequenzleistung einstellbar ist.

Aus der DE 102 478 8 A1 ist ferner eine Einrichtung zur Erzeugung von Plasmen durch Hochfrequenzentladungen bekannt, mit mindestens zwei Elektroden, zwischen denen eine Plasmaentladung unterhalten werden kann, wobei eine Elektrode als Hohlelektrode ausgeführt ist, eine geerdete Fläche eine Gegenelektrode bildet und die der Plasmaentladung abgewandte Seite der Hohlelektrode von einer Abschirmelektrode umschlossen ist. Zwischen Gegenelektrode und Hohlelektrode wird ein zu beschichtendes Substrat angeordnet, so dass das Substrat selbst den Abschluss eines mit einem dichten Plasma erfüllten Raums bildet, und für eine hohe Effektivität der Plasmabehandlung sorgt.

An der Außenseite der Hohlelektrode, im Zwischenraum zwischen Hohlelektrode und Abschirmelektrode, sind Permanent-Magnete angebracht, die für ein Magnetfeld sorgen, das im Inneren der Hohlelektrode zu einer Erhöhung der Plasmadichte führt.

Nachteilig bei den erwähnten gitterlosen Quellen ist, dass die mit dem Plasma zu beaufschlagende Fläche extrem nah an den Plasmaraum herangebracht werden muss und dabei als temporäre Wandung des Plasmagefäßes dienen muss.

Magnetfelder werden auch beim Magnetonsputtern eingesetzt, um die Plasmadichte zu erhöhen und die Sputter-Rate eines von einem Target abgestäubten (gesputterten) Materials bei gleichem Arbeitsdruck zu erhöhen. So ist aus der DE 24 318 32 A ein Kathoden-Zerstäubungsgerät (Magneton-Sputtervorrichtung) bekannt, bei der die aus einer wirksamen Oberfläche einer Kathode aus - und in sie wieder eintretenden magnetischen Kraftlinien zwischen der Aus- und Wiedereintrittsstelle verlaufen und ein tunnelartiger Bereich gegeben ist, in dem geladene Teilchen gehalten werden und in welchem sie sich bewegen können. Die dem Plasma zugewandte Vorderseite der Kathode kann dabei eben sein oder eine konkave oder konvexe Krümmung aufweisen. Ferner kann die Kathode eine Kreis- oder Rechteckform aufweisen. Aus der DE 24 172 88 C2 ist ferner eine Kathoden-Zerstäubungsvorrichtung bekannt, bei der eine Magneteinrichtung derart angeordnet ist, dass von einer Zerstäubungsfläche ausgehende und zu ihr zurückkehrende Magnetfeldlinien einen Entladungsbereich bilden, der die Form einer in sich geschlossenen Schleife hat, wobei die zu zerstäubende und dem zu beschichtenden Substrat zugewandte Kathodenoberfläche eben ist, sich das Substrat nahe dem Entladungsbereich parallel zu der ebenen Zerstäubungsfläche über diese hinweg bewegen lässt und die magnetfelderzeugende Magneteinrichtung auf der der ebenen Zerstäubungsfläche abgewandten Seite der Kathode angeordnet ist.

Bei den bekannten Kathoden-Zerstäubungsvorrichtungen sind die Kathode und eine dieser zugeordneten Anode derartig geschaltet, dass die Kathode auf einem Potenzial unterhalb dem Potenzial der Anode liegt.

Das von der Erfindung zu lösende Problem besteht darin, auf einfache und effektive Weise einen Plasmastrahl zu erzeugen.

Die Aufgabe wird erfindungsgemäß mit den Merkmalen der unabhängigen Ansprüche gelöst.

Bei dem erfindungsgemäßen Verfahren zur Erzeugung eines Plasmastrahls, der aus einem durch elektrische und magnetische Felder erzeugten Plasma dadurch extrahiert wird, dass eine Hochfrequenz-Spannung an eine Extraktionselektrode und eine HF-Elektrodeneinrichtung mit einer Anregungselektrode mit einer Anregungsfläche angelegt wird, wobei zwischen Extraktionselektrode und Anregungsfläche ein Plasmaraum angeordnet ist und das Plasma gegenüber der Extraktionselektrode im zeitlichen Mittel auf einem höheren, positive Plasma-Ionen beschleunigenden Potential liegt und das Plasma und der extrahierte Plasmastrahl durch ein Magnetfeld beeinflusst werden, ist vorgesehen, dass zur Erzeugung des Magnetfeldes zumindest ein magnetischer Nord- und ein magnetischer Südpol verwendet wird, die jeweils auf einer dem Plasma abgewandten Seite hinter der Anregungselektrode angeordnet und in das Innere des Plasmaraums gerichtet sind, so dass ein gekrümmtes in das Innere des Plasmaraums hineinragendes Magnetfeld gebildet wird und wobei zumindest einer der Nord- oder Südpole länglich ausgebildet ist, sodass ein tunnelartiger Bereich im Plasma gebildet wird, in dem geladene Teilchen gehalten werden und entlang derer diese sich ausbreiten können.

Zur Erzeugung des Plasmas wird in den Plasmaraum ein Prozess- und/oder Reaktivgas, vorzugsweise Argon und/oder Sauerstoff geleitet und ggfs. unter Zuhilfenahme eines Druckstosses gezündet.

Zwischen dem erzeugten Plasma und der Extraktionselektrode bildet sich die Schottky Langmuirsche Raumladungsschicht aus, deren Dicke d von der Stromdichte j und dem elektrischen Spannungsabfall U zwischen dem Plasmarand und der Extraktionselektrode abhängt:

$$d = \sqrt{\frac{4\varepsilon_0}{9 \cdot j}} \cdot \sqrt[4]{\frac{2 \cdot e}{m_{ion}}} \cdot U^{\frac{3}{4}}$$

mit

$\varepsilon_0$: Dielektrizitätskonstante des Vakuums
e: Elementarladung

$m_{ion}$: Masse der beteiligten Ionen.

Bei dem erfindungsgemäßen Verfahren werden positive Plasma-Ionen und Elektronen beschleunigt, verlassen durch das Extraktionsgitter hindurch den Plasmaraum und treten als extrahierter, im zeitlichen Mittel neutraler Plasmastrahl in das Innere einer Vakuumkammer ein um auf ein Substrat zu treffen, wobei das Plasma und der extrahierte Plasmastrahl durch ein Magnetfeld beeinflusst werden. Bevorzugt ist vorgesehen, dass die Extraktionselektrode auf Massepotenzial liegt. Wie in der EP 0349556 B1 dargestellt ist, deren Offenbarungsgehalt in vollem Umfang durch Bezugnahme zum Offenbarungsgehalt der vorliegenden Unterlagen gemacht wird, legt sich das Plasma gegenüber der Extraktionselektrode in diesem Fall von selbst auf das höhere, positive Plasma-Ionen beschleunigende Potenzial, da sich ein relativ großer DC-Selfbias ausbildet, wenn das Verhältnis der Größe der von der Extraktionselektrode überdeckten Fläche hinreichend klein ist gegen die Größe der Anregungsfläche. Der auch durch das Magnetfeld beeinflusste DC-Selfbias reflektiert das relative Verhältnis der an der Plasmarandschicht vor der jeweiligen Elektrode abfallenden mittleren Spannungen.

In einer weiteren Ausführungsform der Erfindung kann die Extraktionselektrode mit einer externen Spannungsquelle verbunden und auf diese Weise auf ein von dem Massepotenzial verschiedenes Potenzial gelegt werden, wobei im allgemeinen kein neutraler Plasmastrahl, sondern ein Ionenstrahl erzeugt wird. Mit an sich bekannten Mitteln kann gegebenenfalls eine Aufladung eines mit dem Ionenstrahl beaufschlagten Substrats verhindert werden.

Wenn zur Erzeugung des Magnetfeldes erfindungsgemäß ein magnetischer Nord- und ein magnetischer Südpol verwendet werden, die jeweils auf einer dem Plasma abgewandten Seite hinter der Anregungselektrode angeordnet und in das Innere des Plasmaraums gerichtet sind, so dass ein gekrümmtes in das Innere des Plasmaraum hineinragendes Magnetfeld gebildet wird kann sich ein tunnelartiger Bereich im Plasma bilden, in dem geladene Teilchen gehalten und entlang derer diese sich ausbreiten können, wobei zumindest einer der Nord- oder Südpole länglich ausgebildet ist. Ein derartig erzeugtes Magnetfeld führt vorteilhaft zu einer geringen freien Weglänge der Elektronen im Plasma auch bei einem kleinen Arbeitsdruck bis hinunter zu 5 bis 8 x $10^{-4}$ mbar, abhängig jeweils von der Stärke des Magnetfeldes und ist an sich bereits in dem Kontext des Magnetron-Sputtern bekannt, jedoch nicht für gattungsgemäße HF-Plasmaquellen eingesetzt worden. Bevorzugt sind Magnetfelder an der Oberfläche der Anregungsfläche mit Werten zwischen 10mT und 1500 mT, obwohl auch höhere Feldstärken denkbar sind.

Im Unterschied zu dem vom Magnetron-Sputtern her bekannten Anwendungsfall derartiger Magnetfelder, wird die Anregungselektrode bei dem erfindungsgemäßen Verfahren nicht oder nur geringfügig gesputtert, da die positiven Plasma-Ionen von elektrischen Feldern in Richtung und auf die Extraktionselektrode hin und nicht auf die Anregungselektrode bzw. deren Oberfläche beschleunigt werden.

Die erfindungsgemäße Plasmaquelle zum Durchführen des erfindungsgemäßen Verfahrens mit einem Plasmagefäß mit einer Extraktionselektrode und mit einer HF-Elektrodeneinrichtung mit einer Anregungselektrode mit einer Anregungsfläche, die über ein Anpassungsnetzwerk mit einem HF-Generator verbindbar oder verbunden ist, wobei zwischen Anregungsfläche und Extraktionselektrode ein Plasmaraum liegt, in dem ein Plasma anregbar ist und wobei die Größe der Fläche der Extraktionselektrode und der Anregungsfläche derart gewählt sind, dass nahezu die gesamte Hochfrequenzspannung an der Extraktionselektrode abfällt, und mit einer Magnetvorrichtung zur Erzeugung eines Magnetfeldes, zeichnet sich dadurch aus, dass die Magnetvorrichtung zumindest einen magnetischen Nord- und einen magnetischen Südpol aufweist, die jeweils auf einer dem Plasmaraum abgewandten Seite hinter der Anregungselektrode angeordnet und in das Innere des Plasmaraums gerichtet sind, so dass ein gekrümmtes in das Innere des Plasmaraum hineinragendes Magnetfeld ausbildbar ist, wobei zumindest einer der Nord- oder Südpole länglich ausgebildet ist, so dass ein tunnelartiger Bereich bildbar ist, in dem geladene Teilchen gehalten werden können und entlang welchem sie sich ausbreiten können.

Eine gattungsgemäße Plasmaquelle ist bereits aus der EP 0349556 B1 bekannt, auf die bereits hingewiesen wurde. Im Unterschied zu der bekannten Plasmaquelle ist erfindungsgemäß vorgesehen, dass die Magnetvorrichtung zumindest einen magnetischen Nord- und einen magnetischen Südpol aufweist, die jeweils auf einer dem Plasmaraum abgewandten Seite hinter der Anregungselektrode angeordnet und in das Innere des Plasmaraumes gerichtet sind, so dass ein gekrümmtes in das Innere des Plasmaraum hineinragendes Magnetfeld ausbildbar ist, wobei zumindest einer der Nord- oder Südpole länglich ausgebildet ist, so dass ein tunnelartiger Bereich bildbar ist, in dem geladene Teilchen gehalten werden können und entlang welchem sie sich ausbreiten können.

Analog zu dem erfindungsgemäßen Verfahren, wird bei der erfindungsgemäßen Plasmaquelle, durch eine derartige Magnetvorrichtung bedingt, ein besonders effektiver Elektroneneinschluss und damit eine hohe Plasmadichte mit einer sehr hohen Plasmastromdichte realisiert.

Wenn der tunnelartige Bereich, in dem geladene Teilchen gehalten werden und entlang welchem sie sich ausbreiten können, in sich selbst geschlossen ist, wird der Elektroneneinschluss und die Plasmadichte weiter erhöht.

Die HF-Elektrodeeinrichtung umfasst vorzugsweise einen Elektrodenträger an dem die Anregungselektrode befestigt ist. Der Elektrodenträger kann ein plattenartiges Element mit einer Vorderseite und einer Rückseite aufweisen, wobei die Anregungselektrode an der Vorderseite des Elements angebracht ist. An der Rückseite des Elements des Elektrodenträgers kann die Magnetvorrichtung angeordnet sein.

In einer Ausführungsform der Erfindung kann die Anregungsfläche zumindest in Teilbereichen konkav zum Plasmaraum ausgebildet sein. Ferner kann die Anregungsfläche zumindest in Teilbereichen konvex zum Plasmaraum ausgebildet sein. Die hier verwendete Terminologie für konvex / konkav ist folgende: wenn eine Fläche in einer Umgebung eines Punktes auf derselben Seite der Tangentialebene liegt wie der Beobachter, dann ist sie relativ zum Beobachter konkav gekrümmt; wenn eine Fläche auf der anderen Seite der Tangentialebene liegt wie der Beobachter, dann ist sie dort konvex gekrümmt.

In einer weiteren besonders einfachen Ausführungsform ist zumindest ein Teil der Anregungsfläche planar ausgebildet. Ferner kann die Anregungsfläche tunnelartig oder teilzylinderartig mit einem Öffnungswinkel zum Extraktionsgitter hin ausgebildet sein, wobei es sich versteht, dass die Magnetvorrichtung und ggfs eine Elektrodenhalterung dieser Geometrie angepasst sind.

Besonders bevorzugt ist es, wenn die Magnetvorrichtung wie bei einem planaren Magnetron ausgebildet ist, wie beispielsweise in der DE 2417288 C2 oder in der DE 2431832 B2 beschrieben ist. Insbesondere kann die Magnetvorrichtung als Kreis- oder Rechteck- Magnetron ausgebildet sein. Bei einer Ausbildung der Magnetvorrichtung als Rechteck- Magnetron besteht ein besonderer Vorteil in der einfachen Größenaufskalierung, wobei die von dem Plasmastrahl zu beaufschlagende Fläche vergrößert werden kann, beispielsweise für Durchlaufanlagen, wie Architekturglasbeschichtungsanlagen.

Insbesondere wenn die Magnetronvorrichtung, wie oben erwähnt als Kreis- oder Rechteckmagnetron ausgestaltet ist, können vorteilhaft handelsübliche HF-Elektroden oder Anregungselektroden als Komponenten der Magnetvorrichtung in der erfindungsgemäßen Plasmaquelle verbaut und damit kostengünstige Lösungen gefunden werden. Vorzugsweise wird die Anregungsfläche durch das Sputtertarget derartiger Magnetrons gebildet oder kann von diesen gebildet werden, wobei es sich versteht, dass erfindungsgemäß die Plasmaquelle derart betrieben wird, dass Material der Anregungsfläche nicht oder nur gering abgesputtert wird.

Das Plasmagefäß weist vorzugsweise eine Vorderseite, die in eingebautem Zustand in das Innere einer Vakuumkammer orientiert ist, und eine Rückseite auf, zwischen denen der Plasmaraum liegt. Die Rückseite ist vorzugsweise im Außenbereich der Vakuumkammer angeordnet.

In einer bevorzugten Ausführungsform ist das Plasmagefäß in einer Öffnung einer Vakuumkammerwand angeordnet, wobei das Extraktionsgitter in das Innere der Vakuumkammer orientiert ist. Vorzugsweise ist die Extraktionselektrode als Einfach-Gitter, Lochblech oder Sieb ausgebildet. Es versteht sich jedoch, dass auch Mehrfach-Gitter von der Erfindung mit umfasst werden. Die Extraktionselektrode kann als feines Gitter oder dergleichen ausgebildet sein, deren Öffnungen kleiner oder größer sind als die Dicke der Raumladungsschicht zwischen der Extraktionselektrode und dem Plasma. Falls die Öffnungen größer sind, als die Dicke der Raumladungsschicht zwischen der Extraktionselektrode und dem Plasma kann, wie in der EP 1614138 A2 dargestellt ist, ein divergenter Plasmastrahl erzeugt werden. Der Offenbarungsgehalt der EP 1614138 A2 wird durch Bezugnahme in vollem Umfang zum Offenbarungsgehalt der vorliegenden Unterlagen gemacht.

Das Plasmagefäß kann auch auf die Vakuumkammerwand aufgesetzt sein, so dass zumindest ein Teil des Plasmagefäßes in den Außenbereich der Vakuumkammer ragt.

In einer weiteren Ausführungsform ist der Anregungselektrode eine Dunkelraumabschirmung aus einem leitfähigen Material mit einer Abschirmungsfläche zugeordnet, um die Ausbildung von parasitären Plasmen an der Anregungselektrode zu verhindern. Zwischen der Abschirmungsfläche und Oberflächen der Anregungselektrode befindet sich dabei ein Zwischenraum, der so dimensioniert ist, dass bei Betrieb der Plasmaquelle eine Zündung von unerwünschten Entladungen zwischen der Anregungselektrode und der Dunkelraumabschirmung vermieden wird. Der Abstand zwischen der Abschirmungsfläche der Dunkelraumabschirmung und der entsprechenden Oberfläche der Anregungselektrode ist also kleiner als der Dunkelraumabstand und liegt in einem Bereich zwischen 1 mm und 10mm bevorzugt zwischen 1 mm und 5mm. Bevorzugt liegt die Dunkelraumabschirmung auf Massepotential.

Ein Teil einer Wandung des Plasmagefäßes kann als Dunkelraumabschirmung aus gebildet sein. Ferner können Teile der Wandung des Plasmagefäßes von Teilen einer Wandung der Anregungselektrode gebildet sein.

Ferner kann eine Plasmaelektrode vorgesehen sein, die auf gleichem elektrischem Potential wie die Extraktionselektrode liegt und die eine Plasmaelektrodenoberfläche aufweist, die bei Betrieb der Plasmaquelle in Kontakt mit dem Plasma steht. Bevorzugt steht die Plasmaelektrode mit der Dunkelraumabschirmung in elektrisch leitender Verbindung.

Die Größe der in Kontakt mit dem Plasma stehenden Plasmaelektrodenoberfläche beeinflusst den DC-Selfbias und ist erfindungsgemäß zusammen mit der Größe der Fläche der Extraktionselektrode relativ zur Größe der Anregungsfläche der Anregungselektrode derart gewählt, dass sich das Plasma gegenüber der Extraktionselektrode und der Plasmaelektrode im zeitlichen Mittel auf einem höheren, positive Plasma-Ionen beschleunigendem Potential legt.

In einer weiteren Ausführungsform der Erfindung weist die Anregungselektrode eine Wandung mit einer Innen- und einer Außenseite auf, wobei Teilbereiche der Anregungsfläche auf der Innenseite der Wandung angeordnet sind oder diese bilden und wobei zumindest Teilbereiche der Außenseite von der Abschirmungsfläche der Dunkelraumabschirmung umgeben sind.

In einer weiteren konstruktiv einfachen Ausführungsform der Erfindung ist die Anregungselektrode als Hohlelektrode oder topfartig ausgebildet und weist einen Bodenbereich und Seitenwände auf, wobei zumindest die Seitenwände in den Plasmaraum des Plasmagefäßes hineinragen. Dabei ist vorzugsweise vorgesehen, dass die Dunkelraumabschirmung die Anregungselektrode derart umgibt, dass die Abschirmungsfläche im Bereich der Seitenfläche angeordnet ist. Bevorzugt dabei ist, dass die Dunkelraumabschirmung als Teil der Wandung des Plasmagefäßes und die Plasmaelektrode als Teil der Dunkelraumabschirmung ausgebildet ist, wobei ferner der Bodenbereich der Anregungselektrode einen Teil der Wandung des Plasmagefäßes bildet.

Das Plasmagefäß kann aus einem leitfähigen Material und/oder aus einem Isolatormaterial gebildet sein.

Als Material der Extraktionselektrode und/oder der Plasmaelektrode werden bevorzugt Aluminium oder Metalle wie Titan, Tantal oder Zirkonium eingesetzt. Aluminium weist den Vorteil eines geringen Sputteryieldes, also eines geringen Absputterns durch den Plasmastrahl bei Betrieb der Plasmaquelle mit Sauerstoff auf, erfordert aber bei größeren Hochfrequenzleistungen im Falle als Extraktionselektrode eine aufwendige Kühlung. Titan, Tantal und Zirkonium werden bei Anwendungen der Plasmaquelle bei der Herstellung von optischen Schichten bevorzugt, da keine Kühlung notwendig ist und da aus ihnen bestehendes und bei Betrieb der Plasmaquelle abgesputtertes Material bei Einbau in optische Schichten nur eine relativ geringe Erhöhung der optischen Absorption zur Folge haben, wobei dies für Zirkonium bis in den UV-Bereich des Lichtes hinein gilt.

Die Anregungselektrode sowie die Anregungsfläche können aus gut wärmeleitfähigen Metallen wie Aluminium, Kupfer oder dergleichen gebildet sein. Besonders vorteilhaft ist eine wassergekühlte Ausführung der Anregungselektrode mit mindestens teilweise gebondeter Anregungsfläche, um die thermische Belastung der Plasmaquelle und/oder der Substrate gering zu halten.

Ferner können Anregungsfläche, Extraktionselektrode, die Plasmaelektrode und/oder die Dunkelraumabschirmung einen Teilüberzug aus einem Isolatormaterial wie Quarz aufweisen.

Vorteilhaft ist eine Einrichtung zur Veränderung des Magnetfeldes vorgesehen, mit der die Position von zumindest einem der magnetischen Nord- oder Südpole relativ zur Anregungsfläche und damit die Plasmadichte und daher Ionenenergie und Ionenstrom des Plasmas veränderbar ist. Die Einrichtung kann manuell oder durch einen Motor betrieben werden. Beispielweise kann ein Abstand, insbesondere ein Luftspalt zwischen zumindest einem der magnetische Pole und der Anregungsfläche veränderbar sein oder verändert werden. Vorzugsweise kann, um einen weiten Ionen -Energiebereich abzudecken, die Stärke des Magnetfeldes von einem Wert von 150mT auf einen Wert von 10mT reduziert werden.

Ionenenergie und Ionenstrom des mit dem erfindungsgemäßen Verfahren und der entsprechenden Plasmaquelle erzeugten Plasmastrahls sind in weiten Grenzen variierbar durch die Änderung der des Arbeitsdrucks des Prozessgases, der zugeführten HF-Leistung sowie der Magnetfeldstärke.
Die erfindungsgemäße Plasmaquelle kann vorteilhaft bei einem Arbeitsdruck eines Prozessgases zwischen $10^{-4}$ und $10^{-2}$ mbar betrieben werden und liefert einen Plasma-Strahl mit einem Ionen -Energiebereich zwischen 50 und 1000 eV.

Das erfindungsgemäße Verfahren sowie die Plasmaquelle können vorteilhaft zum plasmaunterstützten reaktiven Magnetronsputtern, wie es beispielsweise aus der WO 2004/050944 A2 bekannt ist, eingesetzt werden. Weitere bevorzugte Anwendungen der Plasmaquelle betreffen die Verbesserung der Schichtqualität bei Beschichtungen unter verschiedenen Einfallswinkeln, wie beispielsweise bei dreidimensionalen Teilen durch hochenergetischen Ionen-Beschuss (vorzugsweise mit Energien in einem Bereich zwischen 100 eV und 800 eV) damit sich glatte, kompakte, streuarme Schichten ergeben, zum Vorreinigen von Substraten durch Sputterätzen oder beim plasmaunterstützten Aufstäuben.

Weitere Aspekte und Vorteile der Erfindung ergeben sich auch unabhängig von ihrer Zusammenfassung in den Patentansprüchen aus den nachfolgenden Ausführungsbeispielen, die anhand von Figuren genauer erläutert werden.

Es zeigen in schematischer Vereinfachung

Figur 1a     eine Querschnittsdarstellung einer erfindungsgemäßen HF-Plasmaquelle

Figur 1b     eine räumliche Darstellung einer Magnetvorrichtung mit einer rechteckigen und

Fig.1c        mit einer kreisförmigen Anregungselektrode einer erfindungsgemäßen Vorrichtung nach Figur 1a

Figur 2 ein Diagramm von Werten eines Ionenstroms und einer Ionenenergie als Funktion der Hochfrequenzleistung von verschiedenen Ausführungsformen der erfindungsgemäßen Plasmaquelle

Figur 3 ein Diagramm von Werten eines Ionenstroms und einer Ionenenergie als Funktion der HF-Leistung einer erfindungsgemäßen Plasmaquelle in Vergleich mit Plasmaquellen gemäß dem Stand der Technik.

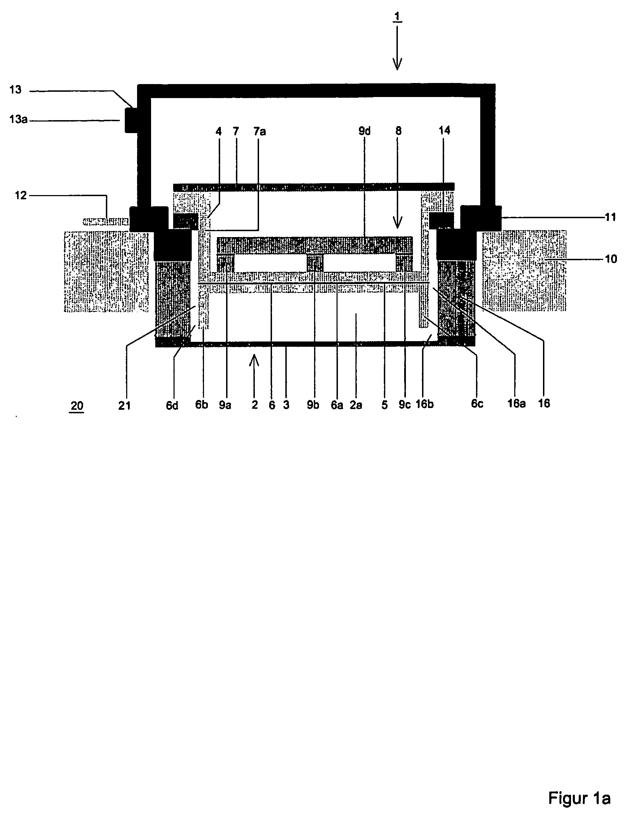

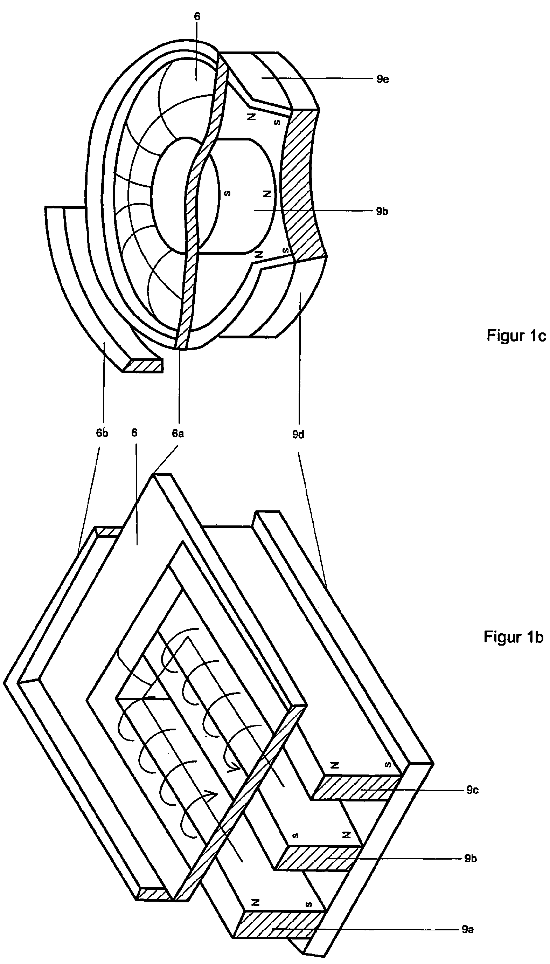

Figur 1 a zeigt in schematischer Darstellung einen Querschnitt einer in eine Vakuumkammer 10 eingebauten erfindungsgemäßen HF- Plasmaquelle 1 mit einem Plasmagefäß 2, einer Extraktionselektrode 3 und einer HF-Elektrodeneinrichtung 4. Über eine Gaszuführungseinrichtung 12 können Prozess- und Reaktivgase, wie Argon und Sauerstoff in das Plasmagefäß 2 eingebracht werden.

Das Plasmagefäß 2 weist eine Vorderseite und eine Rückseite auf, zwischen denen der Plasmaraum 2a liegt. Das Plasmagefäß 2 weist ferner Seitenwände 16 auf, die in das Innere 20 der Vakuumkammer 10 ragen und an deren Stirnseiten die die Vorderseite des Plasmagefäß 2 bildende Extraktionselektrode 3 angebracht ist, die damit den Plasmaraum 2a gegenüber dem Inneren 20 der Vakuumkammer permeabel begrenzt. Die Extraktionselektrode 2 kann auch gekrümmt ausbildet sein.

Das Plasmagefäß 2 kann in einer senkrechten Ebene zu der Zeichenebene der Figur 1 a eine rechteckige oder runde Form aufweisen. Die in Figur 1 a planare Bodenfläche der Anregungselektrode 6 kann auch gegenüber der Extraktionselektrode konkav oder konvex ausgebildet sein. Es versteht sich, dass auch andere Formen des Plasmagefäßes 2 vorstellbar sind und von der Erfindung umfasst werden.

Die Plasmaquelle ist mit einem Flansch 11 in einer Öffnung einer Vakuumkammerwand 10 befestigt. Extraktionsgitter 2 sowie die Wandung 16 sind im Ausführungsbeispiel der Figur 1a elektrisch mit der Vakuumwandkammerwand 10 verbunden und liegen auf Massepotential.

Die Plasmaquelle 1 weist eine teilweise außerhalb des Plasmagefäßes 2 angeordnete HF-Elektrodeneinrichtung 4 auf mit einer Elektrodenhalterung 7, die gegenüber dem Plasmagefäß 2 mittels eines Isolatorelements 14 galvanisch isoliert mit den Seitenwänden 16 des Plasmagefäß 2 verbunden ist und ein plattenförmiges Element 5 umfasst, das von Halteelementen 7a gehalten ist, die in das Innere des Plasmagefäßes 2 hineinragen. Die Elektrodenhalterung 7 hat im Querschnitt eine Badenwannen - ähnliche Form. Die Elektrodeneinrichtung 4 ist rückseitig gegenüber der Umgebung durch eine Schutzabdeckung 13 getrennt, wobei HF-Leistung über eine mit einem HF-Generator verbindbare oder verbundene HF- Einspeisung 13a an die HF-Elektrodeneinrichtung 4 anlegbar ist oder angelegt wird. Ein HF-Anpassungsnetzwerk ist zwar vorhanden, in der Zeichnung jedoch nicht dargestellt.

Die Vorderseite des plattenförmigen Elements 5 ist zum Inneren 20 der Vakuum-Kammer hin orientiert. An der Vorderseite des plattenförmigen Elementes 5 ist die topfartige Anregungselektrode 6 angebracht, die auf ihrer zum Inneren 20 der Vakuum-Kammer hin orientierten Innenseite 6a eine Anregungsfläche aufweist und mit ihrer Außenseite 6d zumindest teilweise in Kontakt mit der Vorderseite des plattenförmigen Elementes 5 steht. Die Anregungselektrode 6 weist einen planaren Boden und daran angebrachte Seitenwände 6c mit Endbereichen (Stirnflächen) 6b auf, die in den Plasmaraum 2 hineinragen. Bevorzugt sind Anregungselektrode 6 und Element 5 gebondet, damit ein guter Wärme- und elektrischer Kontakt zwischen dem plattenförmigen Element 5 und der Anregungselektrode 6 gewährleistet ist. Die Seitenwände 6c werden durch eine Wandung der Anregungselektrode 6 gebildet.

Die Seitenwände 16 des Plasmagefäßes und die Seitenwände 6c der Anregungselektrode sind nahe zu einander liegend angeordnet, voneinander durch einen Spalt 21 getrennt, der so dimensioniert ist, dass sich bei Betrieb der Plasmaquelle zwischen der Anregungselektrode 6 und der Seitenwand 16 kein Plasma ausbilden kann. Die Seitenwände 16 des Plasmagefäßes 2 stellen im Bereich des Spalts 21 daher eine Dunkelraumabschirmung mit einer Abschirmungsfläche 16a der Anregungselektrode 6 dar.

Die Seitenwände 16 des Plasmagefäßes 2 ragen in Richtung des Inneren 20 der Vakuumkammer mit einem Bereich über die Seitenwände 6c hinaus, so dass bei Berieb der Plasmaquelle 1 der Bereich der Seitenwände 16, der über den Endbereich 6b der Seitenwände 6c hinausragt in Kontakt mit dem Plasma steht und eine Plasmaelektrode mit einer Plasmaelektrodenfläche 16b bildet.

Im Betrieb der Plasmaquelle 1 wird die Größe des DC - Selfbias zwischen der Anregungselektrode 6 und der Extraktionselektrode bestimmt durch das Größenverhältnis der Anregungsflächen 6a und 6c zu der Fläche der Extraktionselektrode 3 und der Größe der Plasmaelektrodenfläche 16b, d.h. der in Kontakt mit dem Plasma stehenden Teile der Seitenwände 16 des Plasmagefäßes 2.

Auf der Rückseite der Anregungsfläche 6a und des plattenförmigen Elementes 5 ist die Magnetvorrichtung 8 mit Magneten 9a, 9b, 9c sowie mit einem Pohlschuh 9d angeordnet. Die Magnete 9a, 9b, 9c umfassen jeweiles einen magnetischen Nord- und einen magnetischen Südpol, die mit alternierender Polarität angeordnet und in das Innere des Plasmaraumes 2a gerichtet sind, so dass sich ein gekrümmtes in das Innere des Plasmaraumes hineinragendes Magnetfeld ausbildet, wie an sich beispielsweise aus der DE 241 728 8 C2 oder der DE 243 183 2 B2 bekannt ist. Die Magnete 9a, 9b, 9c können als Permanent-Magnete oder als Solenoide, die an eine Stromversorgung angeschlossen oder anschließbar sind, ausgebildet sein.

In Figur 1 b ist eine mögliche Ausgestaltung einer Magnetanordnung mit Reihen von Magneten 9a, 9b, 9c dargestellt, wobei sich aufgrund der jeweils entgegengesetzten Polarität der Magnete zwischen ihnen ein tunnelartiger Bereich bildet. Die Magnete 9a und 9c der Figur 1 b sind in ihren Endbereichen miteinander verbunden, so dass sich ein in sich selbst geschlossener Tunnel ausbildet.

In Figur 1 c ist eine weitere Ausgestaltung einer Magnetvorrichtung dargestellt, bei der um einen Zentral-Magneten 9b ein kreisförmiger Magnet 9e angeordnet ist, wobei sich ebenfalls ein in sich geschlossener tunnelartiger Bereich ausbildet.

Im Folgenden werden Messergebnisse vorgestellt, die die Vorteile der erfindungsgemäßen Plasmaquelle zeigen. Der Arbeitsdruck bei den angeführten Messungen betrug 4 x 10$^{-3}$ mbar, wobei Sauerstoff als Reaktivgas mit einem Sauerstoff-Fluss von 20 SCCM zugeführt wurde.

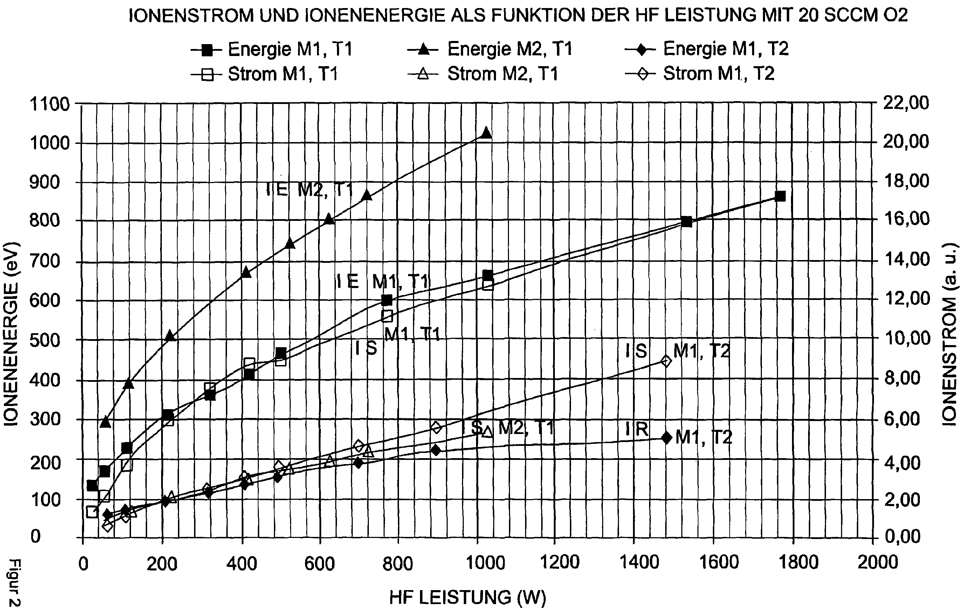

Die Figur 2 zeigt ein Diagramm von Werten eines lonenstromes und einer Ionenenergie für verschiedene Ausbildungsformen einer erfindungsgemäßen Plasmaquelle wobei die mit IS bezeichneten Kurven mit jeweils den Ionenstrom (in willkürlichen Einheiten) und die mit IE bezeichneten Kurven die Ionen-Energie (in eV) in Abhängigkeit von der zugeführten Hochfrequenz-Leistung darstellen. Die mit den Indizes M1T1 bezeichneten Kurven wurden bei einer Plasmaquelle mit einem kreisförmigen Magnetron-Magnetfeld mit einer Hohlelektrode (Hohltarget) mit einem Durchmesser von 200mm und mit 40 Millimeter Seitenhöhe (Mantelhöhe) gemessen. Die mit den Indizes M2T1 bezeichneten Kurven wurden bei einer Plasmaquelle mit der gleichen Hohlelektrode, jedoch mit einem gegenüber dem Fall M1T1 reduzierten Magnetfeld gemessen. Dabei wurde die Magnetanordnung um 25 Millimeter relativ zur Position im Fall M1 von der Anregungselektrode 6 entfernt. Es ist erkennbar, dass damit die Ionen-Energie im Fall M2T1 gegenüber dem Fall M1T1 erhöht wird und dass gleichzeitig die Ionen-Stromdichte im Fall M2T1 geringer ist als im Fall M1T1.

Mit M1T2 sind die Kurven der Ionen-Energien und Ionen-Ströhme für eine Plasmaquelle mit einem Flachtarget und gleicher Magnetvorrichtung wie im Fall M1T1 bezeichnet. Erkennbar ist, dass im Fall M1T2 sowohl Ionen-Energie als auch Ionenstrom gegenüber dem Fall M1T1 reduziert sind. Durch die Ausbildung der Anregungselektrode als Hohlelektrode lässt sich daher ein erhöhter Ionenstrom erreichen. Ferner lassen sich durch Variation der Position der Magnete relativ zur Anregungsfläche relativ einfach Ionen-Energie und Ionenstrom variieren.

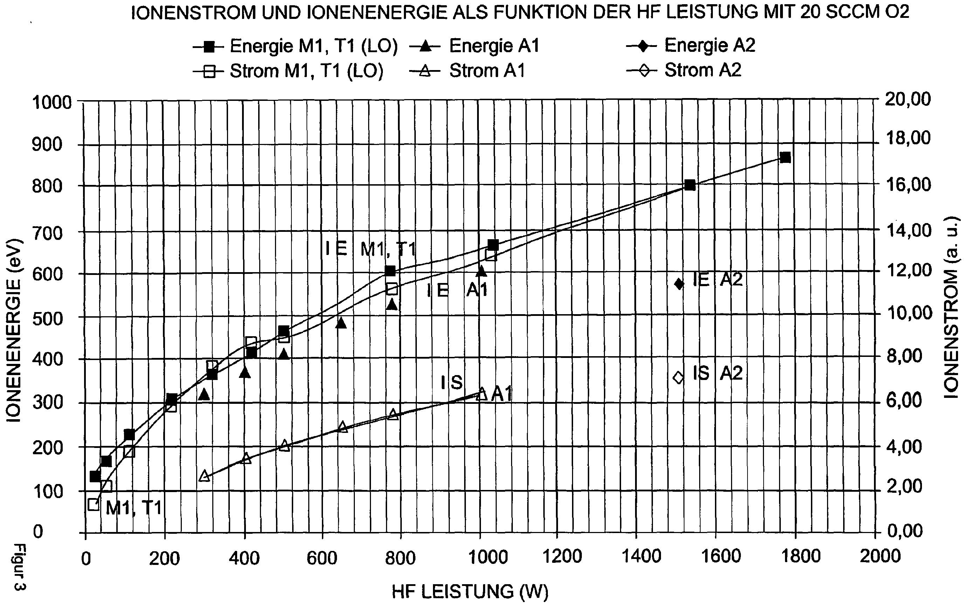

Figur 3 zeigt eine Auftragung von Werten einer Ionen-Energie und eines Ionenstroms im Abhängigkeit von der zugeführten Hochfrequenz-Leistung der erfindungsgemäßen Plasmaquelle im Vergleich zu den entsprechenden Werten zweier Plasmaquellen aus dem Stand der Technik. Hierbei bezeichnen die Kurven mit den Indizes M1T1 eine erfindungsgemäße Plasmaquelle, wie in Figur 2 während die mit IEA1, ISA1 bzw. IEA2, ISA2 bezeichneten Kurven Werte einer kapazitiv angekoppelten bzw. einer induktiv/kapazitiv angekoppelten Plasmaquelle mit jeweils gleichem Durchmesser des Plasmaraums wie die erfindungsgemäße Plasmaquelle bezeichnen. Die erfindungsgemäße Plasmaquelle liefert bei gleicher zugeführter HF-Leistung einen Plasmastrahl mit etwa gleicher hoher Ionen-Energie aber doppelt so hohen Ionenstrom wie die kapazitiv angeregte Quelle nach dem Stand der Technik. Gegenüber der gemischt induktiv/kapazitiv angeregten Quelle liefert die erfindungsgemäße Plasmaquelle bei gleicher zugeführter HF-Leistung einen Plasmastrahl mit etwa 1,5flacher Ionen-Energie und doppelt so hohem Ionenstrom.

## Patentansprüche

1. Verfahren zur Erzeugung eines neutralen Plasmastrahls, der aus einem durch elektrische und magnetische Felder erzeugten Plasma dadurch extrahiert wird, dass eine Hochfrequenz-Spannung an eine Extraktionselektrode (3) und eine HF-Elektroden-Einrichtung (4) mit einer Anregungselektrode (6) mit einer Anregungsfläche angelegt wird, wobei zwischen Extraktionselektrode (3) und Anregungsfläche ein Plasmaraum (2a) angeordnet ist und das Plasma gegenüber der Extraktionselektrode (3) im zeitlichen Mittel auf einem höheren, positive Plasma-Ionen beschleunigenden Potential liegt und das Plasma und der extrahierte Plasmastrahl durch ein Magnetfeld beeinflusst werden,

   **dadurch gekennzeichnet, dass** zur Erzeugung des Magnetfeldes ein planares Magnetron verwendet wird, das auf einer dem Plasma abgewandten Seite hinter der (6) angeordnet und dessen magnetischer Nord- und magnetische Südpole in das Innere des Plasmaraums (2a) gerichtet sind, so dass ein gekrümmtes in das Innere des Plasmaraums (2a) hineinragendes Magnetfeld gebildet wird.

2. Plasmaquelle zum Durchführen des Verfahrens nach Anspruch 1 mit einem Plasmagefäß (2) mit einer Extraktionselektrode (3) und
   mit einer HF-Elektrodeneinrichtung (4) mit einer Anregungselektrode (6) mit einer Anregungsfläche, die über ein Anpassungsnetzwerk mit einem HF-Generator verbindbar oder verbunden ist,
   wobei zwischen Anregungsfläche und Extraktionselektrode (3) ein Plasmaraum (2a) liegt, in dem ein Plasma anregbar ist und wobei die Größe der Fläche der Extraktionselektrode (3) und der Anregungsfläche derart gewählt sind, dass nahezu die gesamte Hochfrequenzspannung an der Extraktionselektrode (3) abfällt
   mit einer Magnetvorrichtung (8) zur Erzeugung eines Magnetfeldes,

   **dadurch gekennzeichnet, dass** die Magnetvorrichtung (8) als planares Magnetron ausgebildet ist, welches zumindest einen magnetischen Nord- und einen magnetischen Südpol aufweist, die jeweils auf einer dem Plasmaraum (2a) abgewandten Seite hinter der Anregungselektrode (6) angeordnet und in das Innere des Plasmaraum (2a) gerichtet sind, so dass ein gekrümmtes in das Innere des Plasmaraums (2a) hineinragendes Magnetfeld ausbildbar ist, so dass ein tunnelartiger Bereich bildbar ist, in dem geladene Teilchen gehalten werden können und entlang welchem sie sich ausbreiten können.

3. Plasmaquelle nach Anspruch 2, **dadurch gekenn-**

zeichnet, dass die Anregungsfläche zumindest in Teilbereichen konkav zum Plasmaraum ausgebildet ist.

4. Plasmaquelle nach einem der Ansprüche 2 bis 3, **dadurch gekennzeichnet, dass** die Anregungsfläche zumindest in Teilbereichen konvex zum Plasmaraum ausgebildet ist.

5. Plasmaquelle nach einem der Ansprüche 2 bis 4 **dadurch gekennzeichnet, dass** zumindest ein Teil der Anregungsfläche planar ausgebildet ist.

6. Plasmaquelle nach einem der Ansprüche 2 bis 5 **dadurch gekennzeichnet, daß** zumindest ein Teil der Extraktionselektrode planar konkav oder konvex ausgebildet ist.

7. Plasmaquelle nach einem der Ansprüche 2 bis 6, **dadurch gekennzeichnet, dass** die Magnetvorrichtung als, vorzugsweise mit einer Hohlelektrode ausgestattete, Kreis- oder Rechteck- Magnetron ausgebildet ist.

8. Plasmaquelle nach einem der Ansprüche 2 bis 7, **dadurch gekennzeichnet, dass** die Anregungselektrode topfartig, mit einem Bodenbereich und Seitenwänden ausgebildet ist und zumindest mit den Seitenwänden in den Plasmaraum hineinragt.

9. Plasmaquelle nach einem der Ansprüche 2 bis 8, **dadurch gekennzeichnet, dass** eine der Anregungselektrode zugeordnete Dunkelraumabschirmung mit einer Abschirmungsfläche vorgesehen ist.

10. Plasmaquelle nach einem der Ansprüche 2 bis 9, **dadurch gekennzeichnet, dass** Teilbereiche der Anregungsfläche auf einer Innenseite einer Wandung der Anregungselektrode angeordnet sind oder diese bilden, und eine Außenseite der Wandung zumindest in Teilbereichen von einer Abschirmungsfläche der Dunkelraumabschirmung umgeben ist.

11. Plasmaquelle nach Anspruch 9 oder 10, **dadurch gekennzeichnet, dass** die Größe der Fläche der Extraktionselektrode und die Größe einer in Kontakt mit dem Plasma stehenden Plasmaelektrodenfläche einerseits und die Größe der Anregungsfläche andererseits derart gewählt sind, dass sich das Plasma gegenüber der Extraktionselektrode im zeitlichen Mittel auf einem höheren, positive Plasma-Ionen beschleunigenden Potential legt.

12. Plasmaquelle nach Anspruch 9 oder 10, **dadurch gekennzeichnet, dass** zumindest ein Teil der Wandungen des Plasmagefässes von Teilen der Dunkelraumabschirmung und/oder Teilen der Anregungselektrode gebildet sind.

13. Plasmaquelle nach einem der Ansprüche 2 bis 12, **dadurch gekennzeichnet, dass** eine Einrichtung zur Veränderung des Magnetfeldes vorgesehen ist.

14. Plasmaquelle nach Anspruch 13, **dadurch gekennzeichnet, dass** eine Einrichtung zur Veränderung des Magnetfeldes vorgesehen ist, mit der die Position von zumindest einem der magnetischen Nord- oder Südpole relativ zur Anregungsfläche veränderbar ist.

15. Plasmaquelle nach Anspruch 13 oder 14, **dadurch gekennzeichnet, dass** eine Einrichtung vorgesehen ist, mit der die magnetische Feldstärke von zumindest einem der magnetischen Nord- oder Südpole veränderbar ist.

**Claims**

1. Method for generating a neutral plasma beam which is extracted from a plasma generated by electric and magnetic fields by means of a radiofrequency voltage being applied to an extraction electrode (3) and an RF electrode device (4) having an excitation electrode (6) having an excitation area, wherein a plasma space (2a) is arranged between extraction electrode (3) and excitation area and the plasma, relative to the extraction electrode (3), on average over time, is at a higher potential which accelerates positive plasma ions, and
the plasma and the extracted plasma beam are influenced by a magnetic field, **characterized in that** a planar magnetron is used for generating the magnetic field, said magnetron being arranged on a side facing away from the plasma behind the excitation electrode (6) and the magnetic north and magnetic south poles of said magnetron being directed into the interior of the plasma space (2a), such that a curved magnetic field projecting into the interior of the plasma space (2a) is formed.

2. Plasma source for carrying out the method according to Claim 1 comprising a plasma vessel (2) comprising an extraction electrode (3) and comprising an RF electrode device (4) having an excitation electrode (6) having an excitation area, which can be connected or is connected to an RF generator via a matching network,
wherein a plasma space (2a) in which a plasma can be excited is situated between excitation area and extraction electrode (3), and wherein the size of the area of the extraction electrode (3) and the size of the excitation area are chosen in such a way that virtually the entire radiofrequency voltage is dropped across the extraction electrode (3),
comprising a magnet apparatus (8) for generating a magnetic field,

**characterized in that** the magnet apparatus (8) is embodied as a planar magnetron having at least one magnetic north pole and one magnetic south pole, which in each case are arranged on a side facing away from the plasma space (2a) behind the excitation electrode (6) and are directed into the interior of the plasma space (2a), such that a curved magnetic field projecting into the interior of the plasma space (2a) can be formed, such that a tunnel-like region can be formed in which charged particles can be held and along which they can propagate.

3. Plasma source according to Claim 2, **characterized in that** the excitation area is embodied in concave fashion with respect to the plasma space at least in partial regions.

4. Plasma source according to either of Claims 2 and 3, **characterized in that** the excitation area is embodied in convex fashion with respect to the plasma space at least in partial regions.

5. Plasma source according to any of Claims 2 to 4, **characterized in that** at least one part of the excitation area is embodied in planar fashion.

6. Plasma source according to any of Claims 2 to 5, **characterized in that** at least one part of the extraction electrode is embodied in planar concave or convex fashion.

7. Plasma source according to any of Claims 2 to 6, **characterized in that** the magnet apparatus is embodied as a circular or rectangular magnetron, preferably equipped with a hollow electrode.

8. Plasma source according to any of Claims 2 to 7, **characterized in that** the excitation electrode is embodied in pot-like fashion, with a base region and side walls, and projects into the plasma space at least with the side walls.

9. Plasma source according to any of Claims 2 to 8, **characterized in that** a dark space shielding assigned to the excitation electrode and having a shielding area is provided.

10. Plasma source according to any of Claims 2 to 9, **characterized in that** partial regions of the excitation area are arranged on an inner side of a wall of the excitation electrode or form the latter, and an outer side of the wall is surrounded by a shielding area of the dark space shielding at least in partial regions.

11. Plasma source according to Claim 9 or 10, **characterized in that** the size of the area of the extraction electrode and the size of a plasma electrode area in contact with the plasma, on the one hand, and the size of the excitation area, on the other hand, are chosen in such a way that the plasma, relative to the extraction electrode, on average over time, acquires a higher potential which accelerates positive plasma ions.

12. Plasma source according to Claim 9 or 10, **characterized in that** at least one part of the walls of the plasma vessel is formed by parts of the dark space shielding and/or parts of the excitation electrode.

13. Plasma source according to any of Claims 2 to 12, **characterized in that** a device for altering the magnetic field is provided.

14. Plasma source according to Claim 13, **characterized in that** a device for altering the magnetic field is provided which can be used to alter the position of at least one of the magnetic north or south poles relative to the excitation area.

15. Plasma source according to Claim 13 or 14, **characterized in that** a device is provided which can be used to alter the magnetic field strength of at least one of the magnetic north or south poles.

**Revendications**

1. Procédé destiné à produire un jet de plasma neutre qui est extrait d'un plasma généré par des champs électriques et magnétiques par application d'une tension à haute fréquence à une électrode d'extraction (3) et à un dispositif à électrodes HF (4) comportant une électrode d'excitation (6) ayant une surface d'excitation, dans lequel une chambre à plasma (2a) est disposée entre l'électrode d'extraction (3) et la surface d'excitation et le plasma se situe à un potentiel d'accélération d'ions plasma positif plus élevé en moyenne temporelle par rapport à l'électrode d'extraction (3), et le plasma et le jet de plasma extrait sont soumis à l'influence d'un champ magnétique,
**caractérisé en ce que**, pour générer le champ magnétique, on utilise un magnétron qui est disposé sur la face opposée au plasma, à l'arrière de l'électrode d'excitation (6) et dont le pôle magnétique Nord et le pôle magnétique Sud sont orientés vers l'intérieur de la chambre à plasma (2a) de manière à former un champ magnétique incurvé pénétrant à l'intérieur de la chambre à plasma (2a).

2. Source de plasma destinée à mettre en oeuvre le procédé selon la revendication 1, comportant une enceinte à plasma (2) ayant une électrode d'extraction (3) et un dispositif à électrode HF (4) comportant une électrode d'excitation (6) ayant une surface d'excitation qui peut être connectée ou est connectée par l'intermédiaire d'un réseau d'adaptation à un générateur HF,

dans laquelle une chambre à plasma (2a) est présente entre la surface d'excitation et l'électrode d'extraction (3), dans laquelle un plasma peut être excité et dans laquelle les tailles de la surface de l'électrode d'extraction (3) et de la surface d'excitation sont sélectionnées de manière à ce que la tension à haute fréquence totale sur l'électrode d'extraction (3) s'abaisse pratiquement au moyen d'un dispositif à aimant (8) destiné à générer un champ magnétique, **caractérisée en ce que** le dispositif à aimant (8) est réalisé sous la forme d'un magnétron plan comprenant au moins un pôle magnétique Nord et un pôle magnétique Sud qui sont respectivement disposés sur une face opposée à la chambre à plasma (2a), à l'arrière de l'électrode d'excitation (6), et qui sont orientés vers l'intérieur de la chambre à plasma (2a) de manière à ce qu'un champ magnétique incurvé puisse être formé à l'intérieur de la chambre à plasma (2a) afin qu'une région en forme de tunnel puisse être formée, à l'intérieur de laquelle des particules chargées peuvent être maintenues et le long de laquelle elles peuvent se propager.

3. Source de plasma selon la revendication 2, **caractérisée en ce que** la surface d'excitation est réalisée au moins dans des régions partielles de manière concave par rapport à la chambre à plasma.

4. Source de plasma selon l'une quelconque des revendications 2 à 3, **caractérisée en ce que** la surface d'excitation est réalisée au moins dans des régions partielles de manière convexe par rapport à la chambre à plasma.

5. Source de plasma selon l'une quelconque des revendications 2 à 4, **caractérisée en ce qu'**au moins une partie de la surface d'excitation est réalisée de manière plane.

6. Source de plasma selon l'une quelconque des revendications 2 à 5, **caractérisée en ce qu'**au moins une partie de l'électrode d'extraction est réalisée de manière plane, concave ou convexe.

7. Source de plasma selon l'une quelconque des revendications 2 à 6, **caractérisée en ce que** le dispositif à aimant est de préférence réalisé sous la forme d'un magnétron circulaire ou rectangulaire équipé d'une électrode creuse.

8. Source de plasma selon l'une quelconque des revendications 2 à 7, **caractérisée en ce que** l'électrode d'excitation est réalisée sous la forme d'une cuve ayant une région de fond et des parois latérales et **en ce qu'**elle pénètre dans la chambre à plasma au moins par l'intermédiaire des parois latérales.

9. Source de plasma selon l'une quelconque des revendications 2 à 8, **caractérisée en ce qu'**il est prévu un écran de chambre noire associé à l'électrode d'excitation et présentant une surface d'écran.

10. Source de plasma selon l'une quelconque des revendications 2 à 9, **caractérisée en ce que** des régions partielles de la surface d'excitation sont formées sur une face interne d'une paroi de l'électrode d'excitation ou forment cette dernière et **en ce qu'**une face externe de la paroi est entourée au moins dans des régions partielles par une surface d'écran de l'écran de chambre noire.

11. Source de plasma selon la revendication 9 ou 10, **caractérisée en ce que** la taille de la surface de l'électrode d'extraction et la taille d'une surface d'électrode à plasma en contact avec le plasma, d'une part, et la taille de la surface d'excitation, d'autre part, sont sélectionnées de manière à ce que le plasma se situe à un potentiel d'accélération d'ions plasma positif plus élevé en moyenne temporelle par rapport à l'électrode d'extraction.

12. Source de plasma selon la revendication 9 ou 10, **caractérisée en ce qu'**au moins une partie des parois de la cuve à plasma est formée par des parties de l'écran de chambre noire et/ou par des parties de l'électrode d'excitation.

13. Source de plasma selon l'une quelconque des revendications 2 à 12, **caractérisée en ce qu'**il est prévu un dispositif destiné à modifier le champ magnétique.

14. Source de plasma selon la revendication 13, **caractérisée en ce qu'**il est prévu un dispositif destiné à modifier le champ magnétique, au moyen duquel la position d'au moins l'un des pôles magnétiques Nord ou Sud peut être modifiée par rapport à la surface d'excitation.

15. Source de plasma selon la revendication 13 ou 14, **caractérisée en ce qu'**il est prévu un dispositif au moyen duquel l'intensité du champ magnétique d'au moins l'un des pôles magnétiques Nord ou Sud peut être modifiée.

Figur 1a

Figur 1c

Figur 1b

Figur 2

IONENSTROM UND IONENENERGIE ALS FUNKTION DER HF LEISTUNG MIT 20 SCCM O2

Figur 3

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 69421033 T2
- DE 10008482 A1
- US 5156703 A
- EP 0349556 B1
- WO 2005008717 A
- DE 4109619 C1
- DE 1024788 A1
- DE 2431832 A
- DE 2417288 C2
- DE 2431832 B2
- EP 1614138 A2
- WO 2004050944 A2